# DEMANDE DE BREVET EUROPEEN

(11) **EP 0 903 914 A1**
(43) Date de publication de la demande: **24.03.1999**
(21) Numéro de dépôt: 98203087.6
(22) Date de dépôt: 16.09.1998
(51) Int. Cl.: H04M 1/72, H04B 1/10, H03G 3/34

(54) **Méthode et système de téléphonie sans fil**

(30) Priorité: 23.09.1997 FR 9711830
(71) Demandeur: Koninklijke Philips Electronics N.V., 5621 BA Eindhoven (NL)
(72) Inventeur: Auffray, Michel, 75008 Paris (FR); Le Nue, Yannick, 75008 Paris (FR)
(74) Mandataire: Chaffraix, Jean

(57) **Abrégé**

Ce système de téléphone comporte un dispositif de base (1) et au moins un dispositif de combiné (2, 3...), pour permettre l'échange de signaux de conversation. Il est prévu :
- des moyens pour transmettre des trames de signaux(51,26-52,40), superposées aux signaux de conversation entre les dispositifs,
- des moyens pour couper les signaux de conversation durant la réception des trames de signaux(55,61-56,62).
en outre, il est prévu du côté du circuit de combiné 2 un circuit de différence (66) pour mesurer l'intervalle de temps entre la coupure des signaux de conversation et la réception de ladite trame de signaux. Ainsi une correction pour modifier l'apparition de ladite coupure en fonction de ladite différence est apportée dans le circuit 62.

Téléphones sans fils.

## Description

L'invention concerne un système de téléphone comportant un dispositif de base et au moins un dispositif de combiné, pour permettre l'échange de signaux de conversation, système comportant :
- des moyens pour transmettre des trames de signaux, superposées aux signaux de conversation entre les dispositifs,
- des moyens pour couper les signaux de conversation durant la réception des trames de signaux.

L'invention concerne aussi un procédé pour couper les signaux de conversation durant les trames de signaux, un dispositif de combiné ainsi qu'un dispositif de base convenant à un tel système.

De tels systèmes sont bien connus et l'invention vise plus précisément les appareils téléphoniques sans fil connus sous la dénomination CT0, CT1, ..CTx.

Un des problèmes qui se pose avec ce genre de système est du à la nécessité de vérifier périodiquement que le dispositif de combiné et le dispositif de base sont valablement reliés entre eux. Pour cela, on transmet, dans une trame de signaux, un code d'identification. Cette transmission de trame se superpose aux signaux de conversation, ce qui est très gênant pour les locuteurs. Aussi, il a été proposé de couper la perception des signaux de conversation pendant la transmission de ces trames de signaux. Cependant par suite de dérive des circuits, il n'est pas toujours possible de s'assurer de la simultanéité de la réception des trames avec la coupure des signaux de conversation et ceci occasionne donc une gêne pour l'utilisateur, puisque ces trames vont apporter des bruits désagréables à l'écoute.

La présente invention propose un système du genre mentionné dans le préambule qui permet de s'assurer de cette simultanéité de ces signaux de trames et de coupure.

Pour cela, un tel système est remarquable en ce qu'il est prévu :
- un circuit de différence pour mesurer l'intervalle de temps entre la coupure des signaux de conversation et la réception de ladite trame de signaux,
- un circuit de correction pour modifier l'apparition de ladite coupure en fonction de ladite différence.

La description suivante, faite en regard des dessins ci-annexés, le tout donné à titre d'exemple non limitatif, fera bien comprendre comment l'invention peut être réalisée.
La figure 1 montre un système conforme à l'invention.
La figure 2 montre un premier diagramme temps explicitant l'invention.
La figure 3 montre un deuxième diagramme temps explicitant l'invention.
La figure 4 montre le détail de réalisation du circuit de commande faisant partie du système de l'invention.

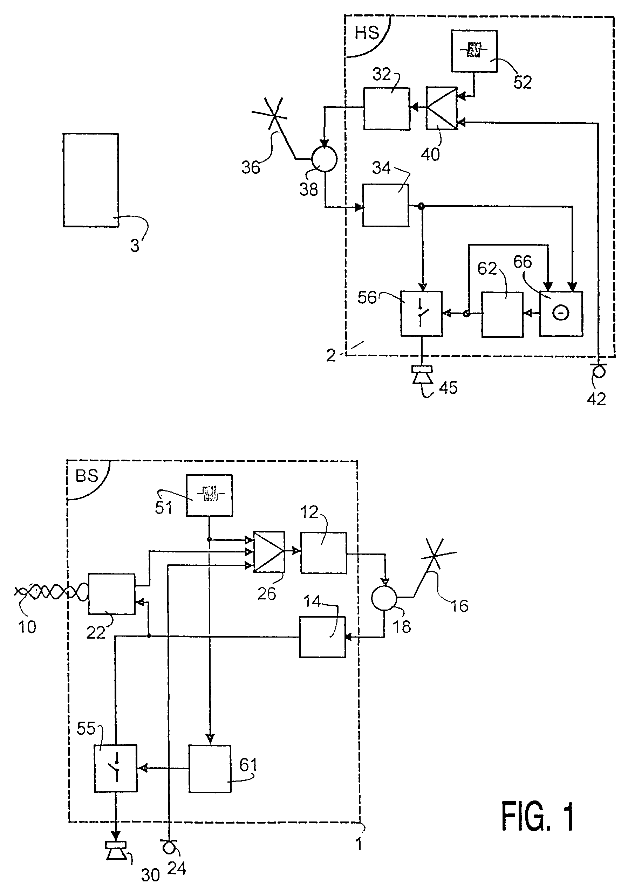

A la figure 1, on a représenté schématiquement le système de l'invention. Il se compose d'un dispositif de base (BS) 1, et d'un certain nombre de dispositifs de combiné 2 et 3. Dans cet exemple décrit, le système comporte deux dispositifs de combiné, en fait il peut en comporter un seul et dans d'autres cas plus de deux. Sur la figure 1, seule la structure du dispositif de combiné (HS) 2 est montrée, le dispositif de combiné 3 pouvant avoir une structure identique.

Le dispositif de base 1 est relié, d'une part, à une ligne téléphonique 10 et, d'autre part, par voie radio, aux dispositifs de combiné 2 et 3. Cette liaison par radio s'effectue au moyen d'un émetteur 12 et d'un récepteur 14, qui émettent et reçoivent des ondes par l'intermédiaire d'une antenne 16. Un circuit de couplage 18 permet à ces émetteur 12 et récepteur 14 d'utiliser cette même antenne 16. L'émetteur peut transmettre des signaux de conversation qui proviennent soit de la ligne téléphonique 10 par l'intermédiaire d'un circuit hybride 22 soit d'un microphone 24. Un circuit d'aiguillage 26 permet de sélectionner les informations à transmettre par l'émetteur 12. Les informations reçues par le récepteur 14 peuvent être dirigées vers un haut parleur 30 et/ou vers la ligne téléphonique 10.

Le dispositif de combiné comporte, lui aussi, un émetteur 32 et un récepteur 34 qui utilisent la même antenne 36 par l'intermédiaire d'un circuit de couplage 38. L'émetteur 32 transmet les informations sélectionnées par un circuit d' aiguillage 40, notamment des signaux de conversation émanant d'un microphone 42. Le récepteur 34 fournit des informations notamment au haut-parleur 45 (ou à un écouteur).

Pour se reconnaître, les dispositifs émettent périodiquement des trames de signaux dans lesquelles sont transmis des codes d'identification. Des générateurs de telles trames sont prévus tant dans le dispositif 1 que dans le dispositif 2 et portent respectivement les références 51 et 52. Ces trames sont superposées aux signaux de conversation et sont ressenties par l'utilisateur, ainsi qu'il a été dit, comme un bruit parasite. Lorsque ces trames sont reçues, on coupe la liaison vers les haut-parleurs 30 et 45 au moyen d'un circuit interrupteur 55 et 56. L'état ouvert ou fermé de ces circuits interrupteurs 55 et 56 est déterminé par des circuits de commandes 61 et 62.

Dans le cadre de l'exemple décrit, les trames sont émises, périodiquement, à l'initiative du dispositif de base 1, le dispositif de combiné émet sa trame dès qu'il a reçu celle de la base. Le circuit de commande 61 détermine la fermeture du circuit-interrupteur à partir de la détection de l'émission de la trame fournie par le générateur 51.

Par contre, pour piloter le circuit de commande 62, il est prévu, conformément à un aspect de l'invention, un circuit de différence 66 qui détermine la différence entre l'instant de la coupure et la trame reçue . Ainsi, ce circuit de différence permet de corriger les dérives de l'apparition de la coupure de la voie de parole.

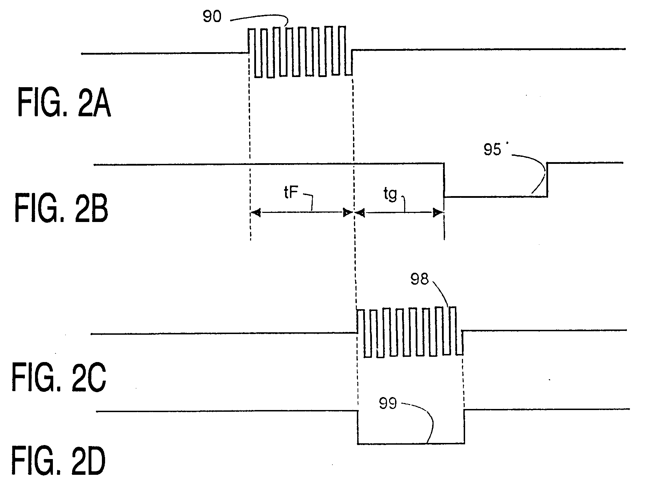

A la figure 2, on a représenté un premier diagramme temps explicitant l'invention.

La référence 90 à la ligne A, montre la trame de signaux émise à partir du dispositif de base (BS) 1 qui est considérée comme étant le dispositif maître, c'est à dire qu'il est le dispositif qui est l'initiateur de l'échange de signaux. La référence 95, à la ligne B, montre l'état ouvert du circuit-interrupteur 56 faisant partie du dispositif 2 considéré comme esclave. C'est ce signal d'ouverture qui subit les effets de dérives précitées. A cause de ces effets, ce signal peut survenir durant une période de temps disjointe de la réception des signaux de trames 90. La figure 2 montre le cas où ce signal d'ouverture (ligne B) survient après la réception du signal de trame, soit après un instant tF + tG après le début du signal émis par le dispositif maître (BS) où "tF" est la durée, déterminée par construction, de la trame et "tg+tF" définit la dérive de temps que l'on veut corriger. La ligne C montre l'émission d'un signal de trame 98 qui survient, tout de suite, après la réception du signal de trame 95. Ce signal 98 est émis par le générateur 52. La ligne D montre le signal d'ouverture 99 du circuit d'interrupteur 55 qui est facilement synchronisable sur le signal émis par le générateur 51.

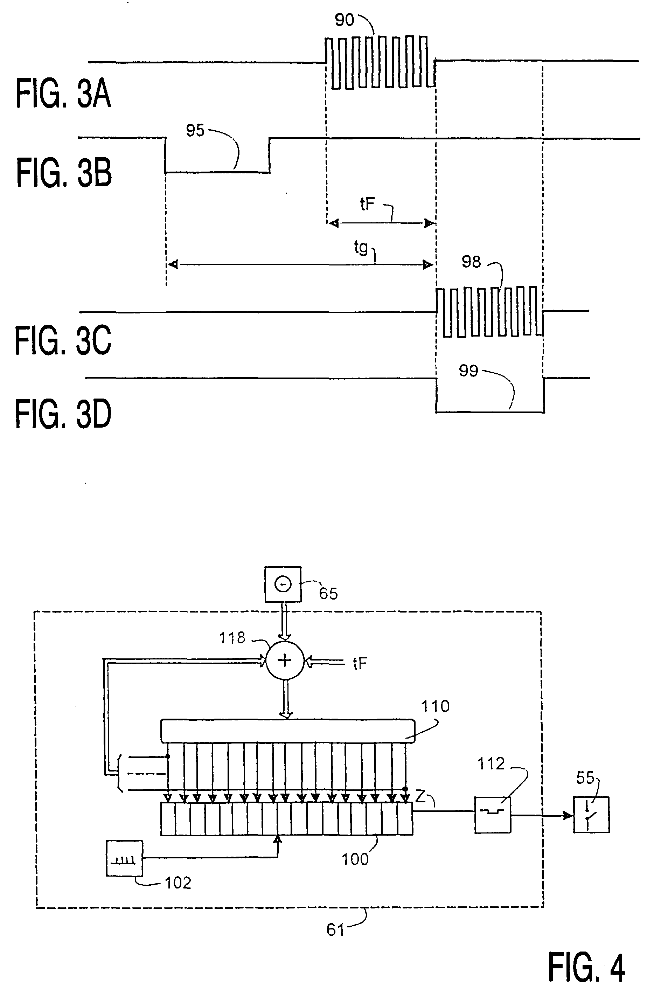

La figure 3 qui est un deuxième diagramme temps montre le cas où la période d'ouverture survient avant la trame de signaux 90.

Selon l'invention, on détermine le temps "tg". Il faut alors apporter une correction en avançant de tF+tg l'apparition de la période d'ouverture pour le cas de la figure 2. Pour le cas de la figure 3, il faut apporter un retard de tg-tF.

La figure 4 montre la structure du circuit de commande 62. Ce circuit de commande 62 est constitué à partir d'un circuit de comptage en l'occurrence, dans le cadre de l'exemple décrit, un décompteur 100 décomptant les impulsions d'une horloge 102. Une position de ce décompteur, le passage à zéro, fournit un signal sur la sortie Z et provoque le chargement de ce décompteur d'une valeur numérique contenue dans un registre 110. Ce passage à zéro déclenche aussi un circuit monostable 112 qui fournit finalement le signal pour mettre à l'état ouvert le circuit-interrupteur 55. Un additionneur numérique 118 effectue l'addition du contenu du registre 110 avec la valeur déterminée par le circuit de différence 65. Comme la détection des trames de signaux s'effectue après son apparition, l'additionneur 118 ajoute la valeur "tF". Ainsi par l'invention les dérives de l'horloge 102 sont corrigées.

Il va de soi que tout autre mode de réalisation de ce circuit 62, notamment en un mode logiciel rentre dans le cadre de l'invention. En outre le rôle de maître et d'esclave peut être échangé. C'est à dire que le dispositif de combiné peut être considéré comme maître et le dispositif de base comme esclave.

## Revendications

1. Système de téléphone comportant un dispositif de base et au moins un dispositif de combiné, pour permettre l'échange de signaux de conversation, système comportant :
- des moyens pour transmettre des trames de signaux, superposées aux signaux de conversation entre les dispositifs,
- des moyens pour couper les signaux de conversation durant la réception des trames de signaux,
caractérisé en qu'il est prévu :
- un circuit de différence pour mesurer l'intervalle de temps entre la coupure des signaux de conversation et la réception de ladite trame de signaux,
- un circuit de correction pour modifier l'apparition de ladite coupure en fonction de ladite différence.

2. Système selon la revendication 1, caractérisé en ce que le circuit de correction est formé d'un circuit de comptage dont le contenu varie en fonction des signaux de sortie du circuit de différence et dont une position fournit le début du signal de coupure.

3. Procédé mis en oeuvre dans un système selon la revendication 1 ou 2 pour couper les signaux de conversation durant les trames de signaux, caractérisé en ce qu'il comporte les étapes suivantes :
- détermination de l'écart de temps entre la coupure et l'apparition de ladite trame,
- correction du temps de la coupure en fonction de ladite détermination.

4. Dispositif d'abonné convenant à un système selon la revendication 1 ou 2, caractérisé en ce qu'il comporte :
- un circuit de différence pour mesurer l'intervalle de temps entre la coupure des signaux de conversation et la réception de ladite trame de signaux,
- un circuit de correction pour modifier l'apparition de ladite coupure en fonction de ladite différence.

5. Dispositif de base convenant à un système selon la revendication 1 ou 2, caractérisé en ce qu'il comporte :
- un circuit de différence pour mesurer l'intervalle de temps entre la coupure des signaux de conversation et la réception de ladite trame de signaux,
- un circuit de correction pour modifier l'apparition de ladite coupure en fonction de ladite différence.
